# FASCICULE DE BREVET EUROPEEN

(11) **EP 0 682 365 B1**
(45) Date de publication et mention de la délivrance du brevet: **07.04.1999**
(21) Numéro de dépôt: 95401050.0
(22) Date de dépôt: 05.05.1995
(51) Int. Cl.: H01L 21/98, H01L 25/10

(54) **Interconnexion en trois dimensions de boîtiers de composants électroniques utilisant des circuits imprimés**
Dreidimensionale Verbindung von Gehäusen elektronischer Bausteine wobei gedruckte Schaltungen angewendet werden
Three-dimensional interconnection of electronic component housings using printed circuits

(30) Priorité: 10.05.1994 FR 9405729
(43) Date de publication de la demande: 15.11.1995
(73) Titulaire: THOMSON-CSF, 75008 Paris (FR)
(72) Inventeur: Val, Christian, F-92402 Courbevoie Cedex (FR); Gerard, André, F-92402 Courbevoie Cedex (FR)
(74) Mandataire: Benoit, Monique

(56) Documents cités:
- EP-A- 0 354 708
- EP-A- 0 434 543
- EP-A- 0 565 391
- EP-A- 0 593 330
- WO-A-88/08203

## Description

La présente invention a pour objet un procédé selon la revendication 1 pour l'interconnexion en trois dimensions de boîtiers montés sur des substrats de type circuit imprimé, chacun des boîtiers encapsulant un composant électronique discret, passif ou actif, ou intégré, pastille semi-conductrice contenant par exemple un circuit intégré ou un ou plusieurs capteurs ; ces composants seront désignés ci-après indifféremment par les termes composant ou pastille.

La réalisation des systèmes électroniques actuels, tant civils que militaires, doit tenir compte d'exigences de plus en plus grandes de compacité, du fait du nombre de plus en plus élevé de circuits mis en oeuvre.

En ce sens, il a déjà été proposé dans la demande de brevet français n° 2.688.630 et la demande de brevet européen EP-A-0 593 330, les deux au nom de THOMSON-CSF, de réaliser des empilements de boîtiers contenant des circuits intégrés. Les boîtiers, munis de broches de connexion, sont empilés puis solidarisés par enrobage dans un matériau isolant, par exemple une résine ; ensuite, l'empilement est découpé au niveau des broches des boîtiers et des connexions entre les broches affleurantes sont réalisées sur les faces de l'empilement.

L'invention a pour objet la réalisation d'empilements du même type, mais selon un procédé de fabrication plus collectif afin d'en réduire les coûts.

A cet effet, les boîtiers de composants sont disposés par exemple selon m lignes et n colonnes sur un substrat isolant, par exemple du type circuit imprimé, sur une ou deux faces de ce dernier ; les zones de connexion des boîtiers sont reliées à des pistes du circuit imprimé, les pistes s'étendant jusqu'aux axes selon lesquels se feront des découpes ultérieures ; une pluralité p de tels circuits imprimés équipés de boîtiers sont alors empilés puis enrobés d'un isolant tel qu'une résine. L'ensemble est ensuite découpé ou détouré selon les axes précédents pour individualiser des barreaux selon les lignes ou les colonnes de boîtiers. Puis on réalise de façon collective les interconnexions des pistes affleurant sur les faces latérales des barreaux, par métallisation puis gravure par exemple. Enfin, le cas échéant, on découpe les barreaux pour former des blocs unitaires, comportant p ou 2p boîtiers empilés et interconnectés.

D'autres objets, particularités et résultats de l'invention ressortiront de la description suivante, donnée à titre d'exemple et illustrée par les dessins annexés, qui représentent :
- la figure 1, un mode de réalisation du procédé selon l'invention ;
- la figure 2a, une vue de dessus de la première étape du procédé de la figure précédente ;
- la figure 2b, un détail agrandi de la figure précédente ;
- la figure 2c, une vue en coupe de la figure 2a ;
- la figure 3, un mode de réalisation de l'empilement de circuits imprimés équipés ;
- la figure 4, un mode de réalisation des interconnexions des pistes sur les faces latérales des barreaux obtenus dans le cours du procédé selon l'invention ;
- les figures 5a et 5b, un mode de réalisation pratique de ces connexions ;
- la figure 6, une variante de réalisation de l'étape d'individualisation des barreaux.

Sur ces différentes figures, les mêmes références se rapportent aux mêmes éléments. En outre, pour la clarté des dessins, l'échelle réelle n'a pas été respectée.

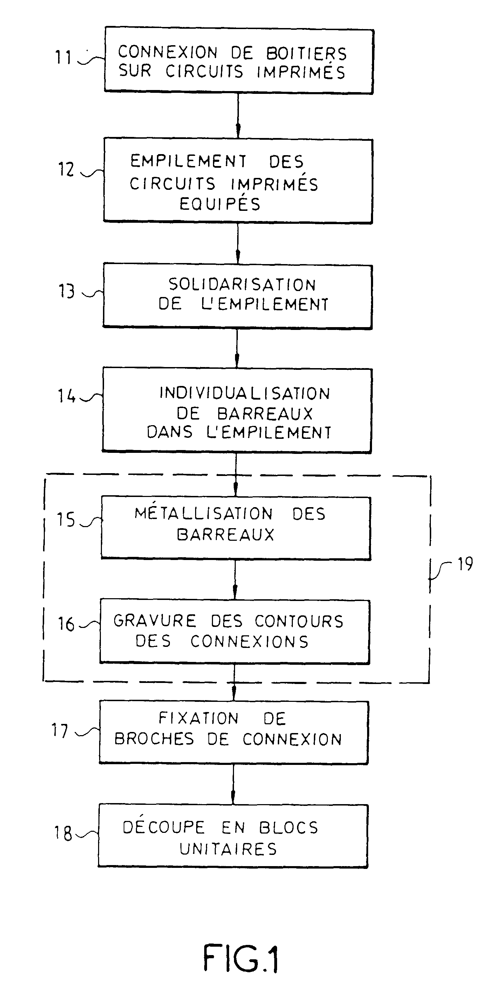

La figure 1 illustre donc un mode de réalisation du procédé selon l'invention.

La première étape du procédé, repérée 11, consiste à disposer un certain nombre de boîtiers sur une ou les deux faces d'un substrat électriquement isolant, par exemple du type circuit imprimé. Le boîtier contient un composant électronique, par exemple une pastille semi-conductrice dans laquelle est réalisée un circuit intégré ; il est en outre muni de zones de connexion, soit des broches, soit des métallisations, avec ou sans bossages.

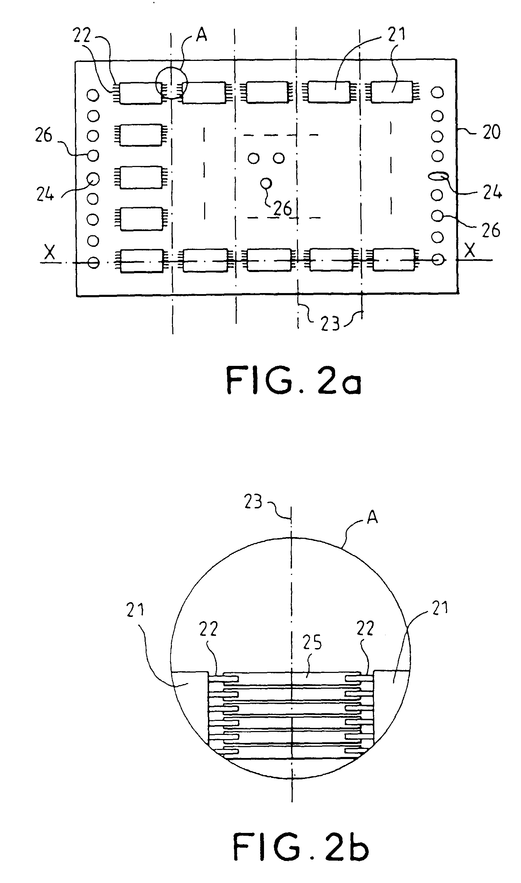

La figure 2a représente une vue de dessus de tels circuits imprimés équipés de boîtiers.

Sur cette figure, on a représenté un substrat 20 du type circuit imprimé, portant des boîtiers 21 arrangés par exemple selon m lignes prises horizontalement sur la figure et n colonnes, prises verticalement. Les boîtiers 21 sont par exemple munis de broches de connexion 22 qui sont électriquement connectées à des pistes conductrices portées par le circuit imprimé 20, comme illustré plus en détail sur la figure 2b, qui représente de façon agrandie la partie A de la figure 2a.

Les broches 22 des boîtiers sont reliées à des pistes 25 qui sont dessinées de sorte à établir une connexion électrique entre les broches 22 et un plan de découpe, représenté par un axe 23, selon lequel sera ultérieurement découpé le circuit imprimé 20. Sur la figure, les pistes 25 ont été représentées droites mais elles peuvent affecter une autre forme, par exemple du type éventail pour permettre un plus grand écartement des pistes au niveau de l'axe de découpe 23.

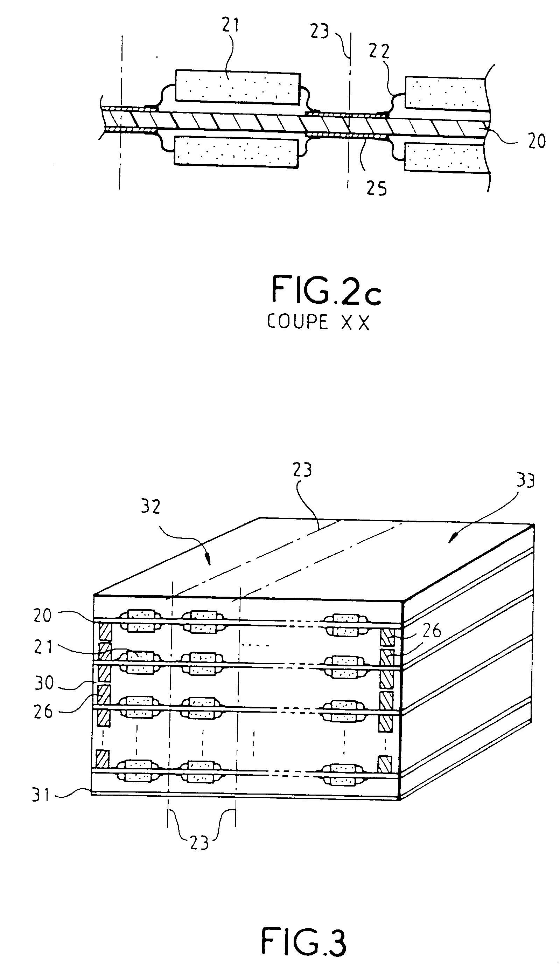

La figure 2c représente une vue en coupe de la figure 2a selon un axe XX passant par les boîtiers 21 d'une même ligne.

On retrouve sur la figure 2c le circuit imprimé 20 portant des boîtiers 21, par exemple sur ses deux faces, les broches 22 de ces boîtiers étant reliées aux plans de découpe 23 par l'intermédiaire des pistes 25.

Le circuit imprimé 20 représenté figure 2a porte encore un certain nombre d'entretoises 26, dont le rôle apparaîtra ci-après. Ces entretoises peuvent être par exemple des petits cylindres à base circulaire ou rectangulaire, réalisés en un métal tel que le cuivre ou encore en un substrat du type circuit imprimé recouvert de cuivre. Ces entretoises sont par exemple brasées, comme les boîtiers 21, sur des emplacements du circuit imprimé 20 préalablement métallisés à cet effet. Elles peuvent également, comme les boîtiers 21, être collées à l'aide de colle électriquement conductrice.

Optionnellement, les brasures peuvent être contrôlées à ce moment, par exemple optiquement, et réparées si nécessaire.

L'étape suivante (12, figure 1) consiste à empiler les circuits imprimés ainsi équipés de boîtiers.

Les différents circuits imprimés empilés sont, de préférence, équipés de boîtiers disposés aux mêmes endroits d'un circuit imprimé à l'autre, et d'entretoises également disposées aux mêmes endroits. De préférence également, les entretoises sont disposées en des zones non chargées de boîtiers, à la périphérie des circuits imprimés et/ou dans une ou plusieurs zones centrales réservées à cet effet. Les entretoises 26 sont, de préférence, un peu plus hautes que les boîtiers de sorte à ménager un espace inter-boîtier. L'empilement est réalisé en utilisant de préférence les trous d'alignement 24, disposés par exemple sur les bords des circuits imprimés 20.

Lors de l'étape suivante, repérée 13, on procède à la solidarisation de l'empilement par enrobage de l'ensemble à l'aide d'un matériau électriquement isolant tel qu'une résine polymérisable, époxy par exemple, qui peut être coulée sous vide.

Le résultat de l'empilement est illustré sur la figure 3, qui est une vue en perspective dont la face avant est une coupe, réalisée également au niveau de l'axe XX de la figure 2a.

Sur cette figure 3, on a représenté l'empilement 33 d'un certain nombre p de circuits imprimés 20, équipés de boîtiers 21 et séparés par des entretoises 26. L'ensemble est noyé dans une résine 30 qui n'a pas été hachuré, bien que vue en coupe, pour la clarté du dessin. On voit que le fait de choisir la hauteur des entretoises 26 supérieure à celle des boîtiers 21 permet d'assurer un bon enrobage des boîtiers par le matériau 30.

Dans un mode de réalisation préféré, l'une des faces au moins, par exemple la face inférieure, est terminée par un substrat de type circuit imprimé 31, permettant de faciliter le routage des connexions.

L'étape suivante, repérée 14 sur la figure 1, consiste à individualiser des barreaux dans l'empilement tel qu'obtenu à l'issue des étapes précédentes et illustré sur la figure 3.

Selon un premier mode de réalisation, l'empilement est découpé selon les plans de découpe 23 afin de former les barreaux 32. La découpe est effectuée par exemple de façon à isoler chacune des colonnes.

A l'issue de la découpe, les zones de connexion 22 des boîtiers 21 sont en contact avec les faces latérales des barreaux par l'intermédiaire des pistes 25.

L'étape suivante (19) consiste à former des connexions entre les boîtiers 21, sur les faces latérales des barreaux 32.

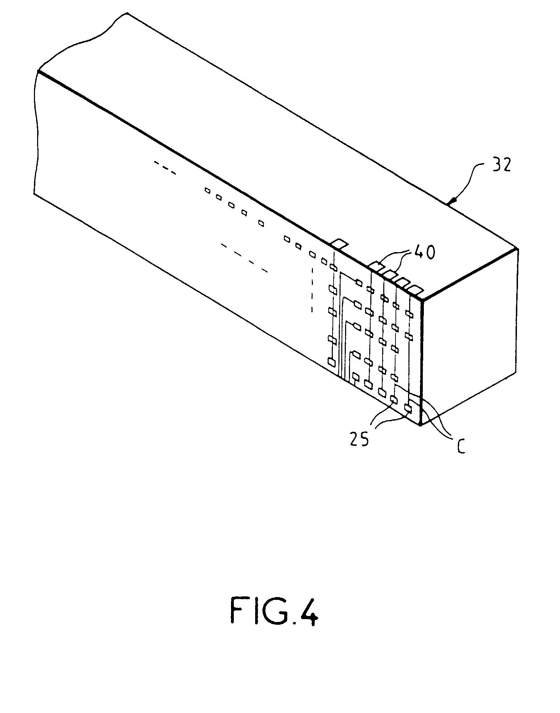

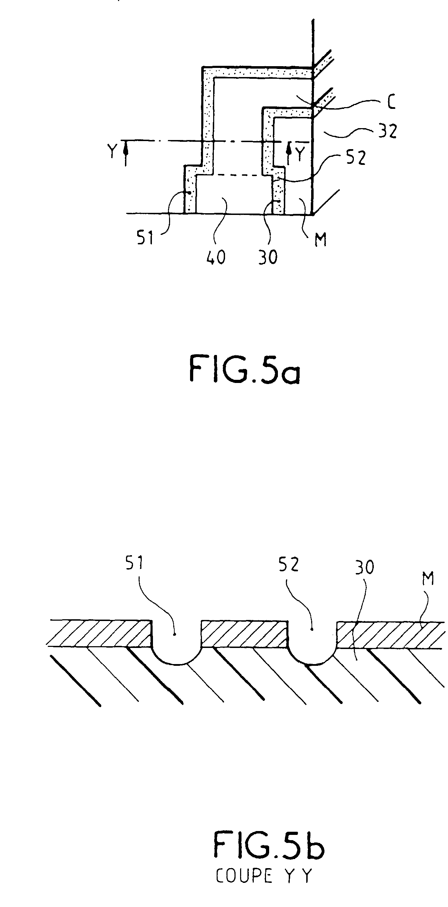

Ces connexions peuvent être formées, par exemple comme illustré figure 1, par une première étape 15 de métallisation de l'ensemble des barreaux ou, au moins, de leurs faces latérales, suivie d'une deuxième étape 16 de gravure des contours des connexions. La métallisation peut être effectuée par voie chimique (Nickel plus Cuivre et Or) ou électrochimique. La gravure peut être réalisée à l'aide d'un laser. Ces étapes sont représentées sur les figures 4, 5a et 5b.

La figure 4 est une vue fractionnaire d'un barreau sur lequel sont illustrés des exemples de connexions.

On a représenté sur cette figure 4 les pistes 25, reliées aux connexions 22, affleurant sur les faces latérales du barreau 32. Le barreau 32 comporte sur une ou plusieurs de ses faces des plots 40, dits plots d'empilement, pour sa liaison électrique à des circuits extérieurs. Les connexions 25 sont à la fois interconnectées entre elles et, quand nécessaire, reliées aux plots d'empilement 40 à l'aide de connexions C.

A titre d'exemple, on a représenté sur la figure le cas où les boîtiers contiennent des mémoires. Dans ce cas, l'ensemble de leurs broches homologues sont reliées entre elles et à un plot d'empilement 40, sauf une pour chacun des boîtiers qui correspond à l'entrée de sélection de la mémoire. Ces broches de sélection sont alors reliées individuellement, par exemple par l'intermédiaire du circuit imprimé de fermeture situé sous l'empilement, à des plots d'empilement distincts, non visibles sur la figure.

Les figures 5a et 5b illustrent plus en détail un mode de réalisation des connexions C.

La figure 5a représente une vue fractionnaire d'un morceau d'un barreau 32 où l'on voit une connexion C et un plot d'empilement 40. La figure 5b est une vue en coupe selon un axe YY de la figure 5a.

Chacune des connexions C est formée par deux gravures 51 et 52, réalisées par exemple à l'aide d'un laser qui détruit localement la couche conductrice, repérée M, et fait apparaître le matériau isolant d'enrobage 30 ; ce matériau 30 a été représenté en pointillés sur la figure 5a pour la clarté du schéma. De la sorte, on réalise l'isolation électrique de la connexion C du reste de la couche M. Les plots d'empilement 40 peuvent être avantageusement réalisés par la même technique de gravure laser, comme représenté sur la figure 5a.

L'étape suivante, repérée 17 sur la figure 1, est optionnelle et consiste à fixer sur le barreau précédent des broches de connexion, permettant sa connexion avec des circuits extérieurs.

Enfin, la dernière étape (18) consiste à découper le barreau précédemment obtenu en blocs unitaires, chacun des blocs étant alors constitué par p boîtiers empilés si le support 20 est simple face, ou 2p boîtiers s'il est double face.

Cette dernière étape est optionnelle. En effet, il peut être avantageux, dans certaines applications, de disposer d'un composant unique comportant m x p ou m x 2p boîtiers, ceux-ci pouvant en outre être interconnectés entre eux lors de l'étape 19 et/ou à l'aide du (ou des) circuit(s) imprimé(s) de fermeture.

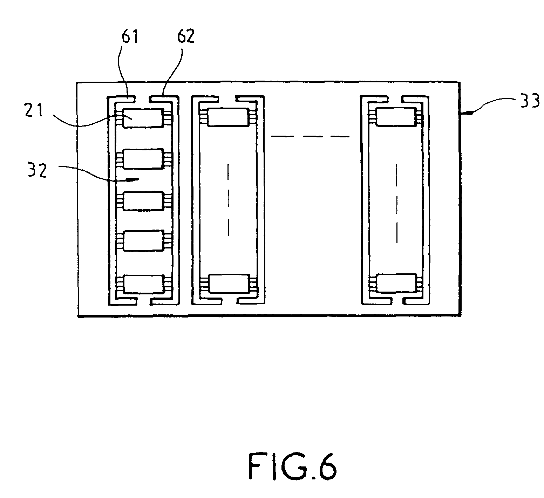

La figure 6 représente une variante de réalisation de l'étape 14 d'individualisation des barreaux, qui consiste non plus à les découper mais à les détourer.

Sur la figure 6, on a représenté l'empilement 33 vu de dessus. Afin d'individualiser les barreaux 32, on réalise autour de chacun d'eux deux fentes 61 et 62 non jointives, de sorte que le barreau continue à être solidaire de l'empilement 33. Les fentes sont réalisées comme précédemment les découpes, de sorte à faire affleurer sur les surfaces latérales des fentes les connexions 25, elles-mêmes reliées aux broches 22 des boîtiers 21.

L'ensemble des étapes ultérieures reste inchangé, à ceci près que elles sont encore plus collectives du fait que l'ensemble des barreaux de l'empilement 33 peut être traité en même temps puisque ceux-ci restent solidaires entre eux.

Il a été décrit ci-dessus une méthode d'interconnexion 3D de boîtiers qui permet de réaliser les opérations de formation des interconnexions (C) et, le cas échéant, de fixation de broches de connexion, de façon collective pour un ensemble de blocs (m ou n ou mxn), et par là même de façon plus économique. En outre, les blocs étant solidaires les uns des autres à l'intérieur d'un barreau, aucune opération de positionnement des blocs les uns par rapport aux autres n'est nécessaire.

La description faite ci-dessus l'a été à titre d'exemple et d'autres variantes sont possibles. C'est ainsi par exemple que les circuits imprimés 20 peuvent ne porter chacun qu'une seule ligne (ou une seule colonne) de boîtiers 21 ; également, les circuits imprimés 20 peuvent porter des métallisations (non représentées), formant drain thermique, débouchant sur une des faces des blocs (de préférence, une face ne portant pas de connexion C).

## Revendications

1. Procédé d'interconnexion en trois dimensions d'une pluralité de boîtiers (21), chacun des boîtiers contenant au moins un composant électronique et étant muni de zones de connexion (22), le procédé étant caractérisé par le fait qu'il comporte les étapes suivantes :
• connexion (11) des zones de connexion à des pistes (25) conductrices portées par des substrats (20) électriquement isolants, les pistes s'étendant jusqu'à des axes pré-définis dits de découpe (23) ;
• empilement (12) des substrats ;
• solidarisation (13) par enrobage dans un matériau (30) électriquement isolant ;
• découpe (14) de l'empilement selon les axes de découpe de sorte à obtenir des barreaux individualisés (32) , les portions de substrats de chaque barreau portant une pluralité de boîtiers ;
• formation (19) de connexions électriques (C) entre les pistes, sur les faces des barreaux .

2. Procédé selon la revendication 1, caractérisé par le fait que le matériau (30) isolant est une résine polymérisable.

3. Procédé selon l'une des revendications précédentes, caractérisé par le fait que l'étape (19) de formation de connexions électriques se décompose en deux sous-étapes :
- la première sous-étape (15) consistant en un dépôt d'une couche conductrice (M) sur l'ensemble des faces de l'empilement ;
- la deuxième sous-étape (16) consistant en une gravure de la couche conductrice pour former des connexions électriques (C) reliant les conducteurs entre eux.

4. Procédé selon l'une des revendications précédentes, caractérisé par le fait que les réalisations de gravures (16) sont faites à l'aide d'un laser.

5. Procédé selon l'une des revendications précédentes, caractérisé par le fait que, lors de l'étape (19) de formation de connexions électriques, sont formés en outre des plots dits d'empilement (40), destinés à la connexion de l'empilement avec des circuits extérieurs, et que les connexions électriques (C) relient entre elles au moins certaines des zones de connexion (22) et les plots d'empilement.

6. Procédé selon l'une des revendications précédentes, caractérisé par le fait qu'il comporte en outre, après l'étape (19) de formation de connexions électriques entre les pistes, une étape (18) de découpe des barreaux pour former des blocs unitaires, les substrats de chaque bloc portant un seul boîtier.

7. Procédé selon l'une des revendications précédentes, caractérisé en ce que les zones de connexion (22) des boîtiers sont des broches ou des métallisations.

## Claims

1. Method for the 3D interconnection of a plurality of packages (21), each of the packages containing at least one electronic component and being provided with connecting regions (22), the method being characterized in that it comprises the following steps:
* connection (11) of the connection regions to conductive tracks (25) borne by electrically insulating substrates (20), the tracks extending up to predefined so-called slicing axes (23);
* stacking (12) of the substrates;
* joining together (13) by shrouding in an electrically insulating material (30);
* slicing (14) of the stack along the slicing axes so as to obtain individualized bars (32), the portions of substrates of each bar bearing a plurality of packages;
* formation (19) of electrical connections (C) between the tracks, on the faces of the bars.

2. Method according to Claim 1, characterized in that the insulating material (30) is a polymerizable resin.

3. Method according to one of the preceding claims, characterized in that the step (19) for the formation of electrical connections comprises two sub-steps:
- the first sub-step (15) consisting of a deposition of a conductive layer (M) on all the faces of the stack;
- the second sub-step (16) consisting of an etching of the conductive layer to form electrical connections (C) linking the conductors to one another.

4. Method according to one of the preceding claims, characterized in that the operations for making the etchings (16) are carried out by means of a laser.

5. Method according to one of the preceding claims, characterized in that, during the step (19) for the formation of electrical connections, there are furthermore formed so-called stack pads (40), designed for the connection of the stack with external circuits, and in that the electrical connections (C) link at least certain of the connection regions (22) and stack pads with one another.

6. Method according to one of the preceding claims, characterized in that it further comprises, after the step (19) for the formation of electrical connections between the tracks, a step (18) for the slicing of the bars to form unit blocks, the substrates of each block bearing only one package.

7. Method according to one of the preceding claims, characterized in that the connection regions (22) of the packages are pins or metallizations.

## Patentansprüche

1. Dreidimensionales Verbindungsverfahren für eine Vielzahl von Gehäusen (21), die je mindestens ein elektronisches Bauteil enthalten und Anschlußzonen (22) besitzen, dadurch gekennzeichnet, daß das Verfahren folgende Schritte aufweist:
• Anschluß (11) der Anschlußzonen an Leiterbahnen (25), die sich auf elektrisch isolierenden Substraten (20) befinden, wobei sich die Leiterbahnen bis zu vordefinierten sogenannten Schnittachsen (23) erstrecken;
• Stapelung (12) der Substrate;
• Zusammenfügung des Stapels (13) durch Ummantelung mit einem elektrisch isolierenden Material (30) ;
• Zerschneiden (14) des Stapels gemäß den Schnittachsen, sodaß sich indiviualierte Leisten (32) ergeben, wobei die Substratteile jeder Leiste je mehrere Gehäuse tragen;
• Bildung (19) von elektrischen Verbindungsleitungen (C) zwischen den Leiterbahnen auf den Flächen der Leisten.

2. Verfahren nach Anspruch 1, dadurch gekennzeichnet, daß das isolierende Material (30) ein polymerisierbares Harz ist.

3. Verfahren nach einem der vorhergehenden Ansprüche, dadurch gekennzeichnet, daß der Schritt (19) der Bildung von elektrischen Verbindungsleitungen sich in zwei Teilschritte gliedert:
- der erste Teilschritt (15) besteht darin, daß eine leitende Schicht (M) auf alle Seiten des Stapels aufgebracht wird;
- der zweite Teilschritt (16) besteht darin, die leitende Schicht zu gravieren, um elektrische Verbindungsleitungen zwischen den Leiterbahnen zu bilden.

4. Verfahren nach einem der vorstehenden Ansprüche, dadurch gekennzeichnet, daß die Gravur (16) mit einem Laser erfolgt.

5. Verfahren nah einem der vorstehenden Ansprüche, dadurch gekennzeichnet, daß während des Verfahrensschritts (19) der Bildung elektrischer Verbindungsleitungen außerdem sogenannte Stapelanschlußpunkte (40) gebildet werden, die zum Anschluß des Stapels an äußere Schaltungen bestimmt sind, und daß die elektrischen Verbindungsleitungen (C) zumindest bestimmte der Anschlußzonen (22) und die Stapelanschlußpunkte miteinander verbinden.

6. Verfahren nach einem der vorstehenden Ansprüche, dadurch gekennzeichnet, daß außerdem nach den Verfahrensschritten (19) der Bildung elektrischer Verbindungsleitungen zwischen den Leiterbahnen ein Verfahrensschritt (18) vorgesehen ist, bei dem die Leisten in Einheitsblöcke zerschnitten werden, wobei die Substrate jedes Blocks nur ein Gehäuse tragen.

7. Verfahren nach einem der vorstehenden Ansprüche, dadurch gekennzeichnet, daß die Anschlußzonen (22) der Gehäuse Anschlußstifte oder metallbeschichtete Zonen sind.
